Europäisches Patentamt

European Patent Office

Office européen des brevets

(11) Publication number: **0 337 457**
**A2**

## (12) EUROPEAN PATENT APPLICATION

(21) Application number: **89106630.0**

(22) Date of filing: **13.04.89**

(51) Int. Cl.⁴: **G11C 8/00**

(30) Priority: **13.04.88 JP 91083/88**

(43) Date of publication of application:
**18.10.89 Bulletin 89/42**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Nogami, Kazutaka c/o Intellectual**
**Property Div.**
**Kabushiki Kaisha Toshiba 1-1 Shibaura**
**1-chome**
**Minato-ku Tokyo 105(JP)**

(74) Representative: **Henkel, Feiler, Hänzel &**
**Partner**
**Möhlstrasse 37**
**D-8000 München 80(DE)**

(54) **Memory device having a plurality of memory cell arrays with different organization.**

(57) A memory circuit built into a single-chip integrated circuit includes a first memory cell array (1), and a second memory cell array (2) having a structure different from the structure of the first memory cell array, commonly using part (Ai to Aj) of addresses with the first memory cell array, and having the same number of rows as said first memory cell array. The first and second memory cell arrays are commonly connected to decoding means (3) for decoding the commonly used addresses (Ai to Aj). Each word line (WL) is connected commonly to memory cells (6) of the corresponding row of the first and second memory cell arrays (1, 2). When the potential of a word line is set to the active level, connected memory cells are selected. The decoder is connected to the word lines (WL), to decode the row addresses (Ai to Aj) and set the potential of a word line (WL) corresponding to the row addresses to the active level.

F I G. 3

## Memory device having a plurality of memory cell arrays with different organization

The present invention relates to a semiconductor integrated circuit, and, in particular, to a semiconductor integrated circuit having a plurality of memory cell arrays constituted by a plurality of memory cells with different organization or a plurality of different cells in a single chip.

There are logic LSIs (large-scale integrated circuits) including memories or memory LSIs, each of which has a plurality of memory cell arrays with different structures in a single chip. In this case, the memory cell arrays with different structures include 1) memory cell arrays with different storage capacities, 2) memory cell arrays with different parallel input/output bit numbers, and 3) memory cell arrays constituted by different memory cells (for example, a combination of one-port memory cells and two-port memory cells, or a combination of static memory cells and dynamic memory cells).

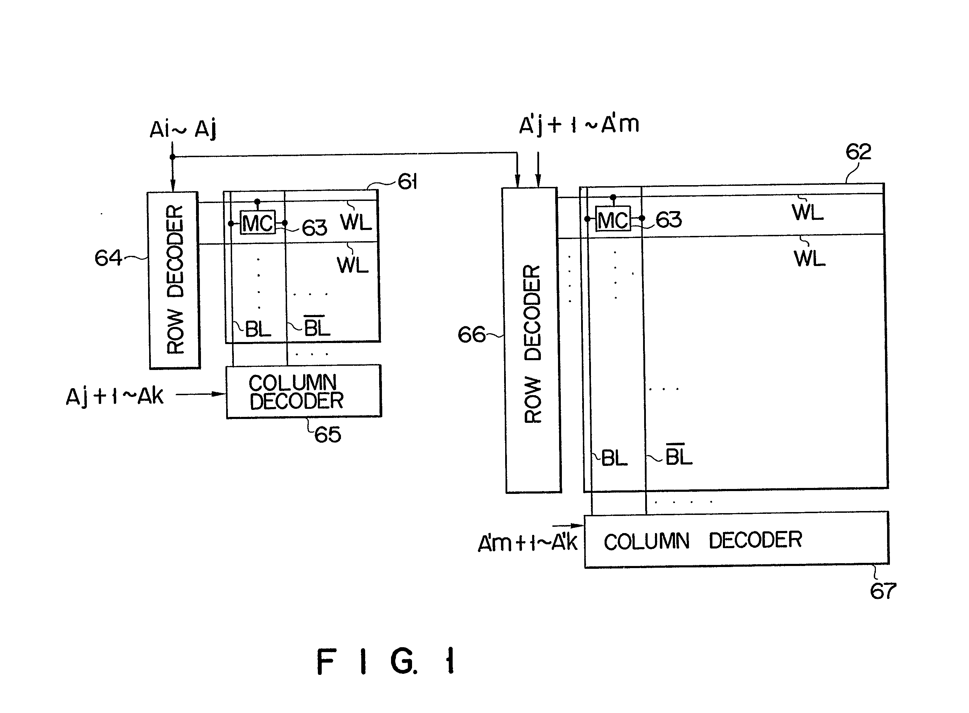

Fig. 1 shows an example of the LSI having memory cell arrays with different structures in a single chip. The LSI shown in Fig. 1 includes two memory cell arrays, 61 and 62, having different organization, to which some (Ai to Aj) of address signals are commonly supplied. While the memory cells constituting memory cell arrays 61 and 62 have the same structure, the storage capacity of cell array 61 differs from that of cell array 62, and for this reason, each memory cell array is designed so that a maximum operation speed can be obtained in relation to storage capacity. As a result, memory cell arrays 61 and 62 have substantially square patterns. In Fig. 1, symbol WL indicates a word line, BL and BL bit lines, numerals 64 and 65 a row decoder and a column decoder for memory cell array 61, and 66 and 67 a row decoder and a column decoder for memory cell array 62. Memory cell arrays 61 and 62 commonly use some (Ai to Aj) of addresses. Address signals for memory cell array 61 are indicated by Ai to Aj (common address part) and Aj+1 to Ak, and address signals for memory cell array 62 are indicated by Ai to Aj (common address part) and Aj+1 to $A'm$, and $A'm+1$ to $A'k$.

With the above structure, the length of wiring for common address signals Ai to Aj increases, as does the floating capacity of an address line, the address signals decoding time becomes longer, and the operation speed of the LSI decreases. In particular, in the case of a static RAM (Random Access Memory), the decoding time of the address signals occupies 40% to 50% of the access time. Thus if the capacity of the address signal lines increases, the operation speed of the LSI is lowered considerably. In the case where the sizes (occupation areas) of two memory cell arrays 61 and 62 differ significantly from each other, a non-used area is likely to occur within a chip. In particular, such a non-used area is like to occur in a chip in which memory cell arrays occupy a large area. Consequently, the chip size becomes undesirably larger, resulting in a decrease in the gross number of chips per wafer, and an increase in the manufacturing cost of the resulting LSIs.

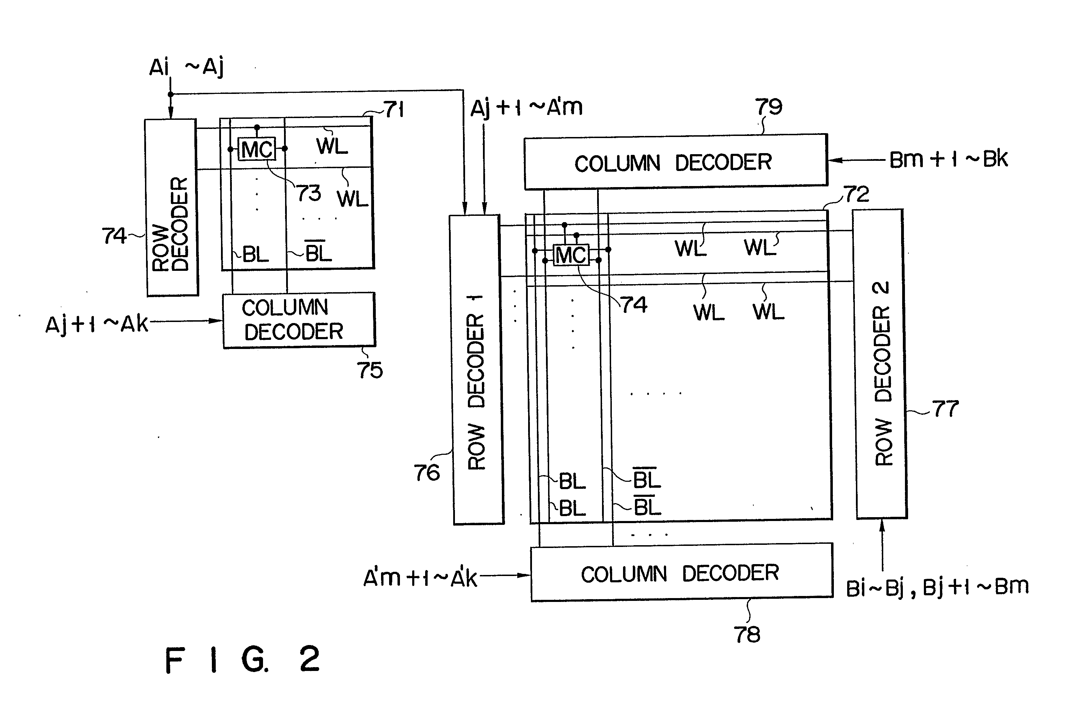

Fig. 2 shows a circuit structure of a conventional cache memory. The cache memory shown in this Figure comprises different memory cells. In this memory, two memory cell arrays, 71 and 72, which commonly use some (Ai to Aj) of address signals, are arranged within a single chip. Memory cell array 71 is a one-port memory array made up of one-port memory cells 73, while memory cell array 72 is a two-port memory cell array made up of two-port memory cells 73. In Fig. 2, symbol WL indicates a word line, and BL and BL bit lines. Reference numerals 74 and 75 denote a row decoder and a column decoder for memory cell array 71, 76 and 78 a first row decoder and a first column decoder for memory cell array 72, and 77 and 79 a second row decoder and a second column decoder for memory cell array 72. Address signals for memory cell array 71 are indicated by Ai to Aj and Aj+1 to Ak. Address signals for a first port of memory cell array 72 are indicated by Ai to Aj (common address part) and Aj+1 to $A'm$, and $A'm+1$ to $A'k$, and address signals for a second port of memory cell array 72 are indicated by Bi to Bj and Bj+1 to Bm, and Bm+1 to Bk.

The cache memory of the above structure is used, for example, in a computer system of the type wherein a CPU (Central Processing Unit) bus and a system bus are separated. The two-port memory is accessed from both the system bus side and the CPU bus side, whereas the one-port memory is accessed only from the CPU bus side. In this case, address signals Ai to Aj from the CPU bus side are commonly used by cell arrays 71 and 72.

In the structure of Fig. 2, as in the structure of Fig. 1, the floating capacity of the commonly used address signal lines increases and the operation speed decreases. In particular, in the case of cache memory, the address signals which are commonly used are supplied from the CPU. Since high-speed operation is required in the CPU, the degradation in performance due to the floating capacity is significant.

The object of the present invention is to provide a semiconductor integrated circuit having a small chip size, and which is capable of high-speed operation.

In order to achieve the above object, a one-chip semiconductor memory of the present invention comprises:

a first memory cell array (1) for storing information;

a second memory cell array (2) having a structure different from that of said first memory cell array and using part (Ai to Aj) of address signals commonly with the first memory cell array; and

decoder (3) for decoding the common address signals (Ai to Aj) supplied to the first and second memory cell arrays.

With the above structure, a plurality of memory cell array are commonly connected to decoder. Thus, the capacity of the commonly used address signal lines is decreased, and high-speed operation can therefore be realized. If the plural memory cell arrays are arranged in series in the direction of columns of the arrays, the memory cell arrays can be arranged in a rectangular pattern as a whole. As a result, the area on the chip occupied by the one chip semiconductor memory is made smaller, the chip size can be reduced, and the chip cost decreased.

If, in the case of a plurality of memory cell arrays having different memory cells, the row pitch (word line pitch) is suitably set, the number of rows of the two arrays can be made equal and single row decoder can be commonly used by the two arrays. Also, in the case where a memory cell array formed of static-type memory cells and one formed of dynamic-type memory cells are jointly provided, it is possible for the row decoding means to be commonly used by both arrays, enabling high-speed operation to be attained and the chip made smaller in size.

This invention can be more fully understood from the following detailed descrition when taken in conjunction with the accompanying drawings, in which:

Figs. 1 and 2 show circuit structures of conventional semiconductor integrated circuits.

Figs. 3 to 7 show circuit structures of semiconductor integrated circuits according to embodiments of the present invention, of which:

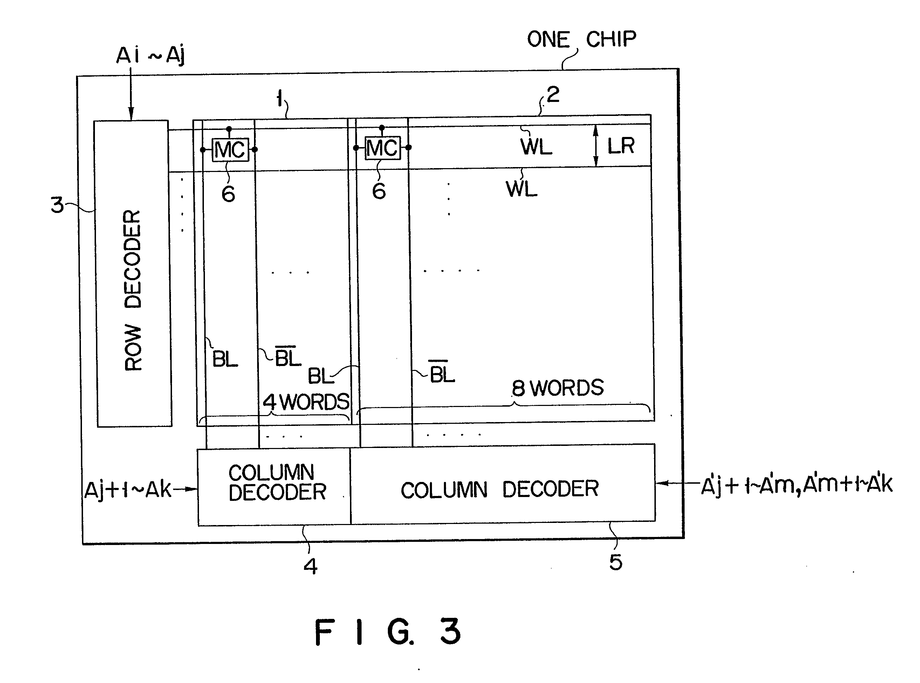

Fig. 3 is a block diagram showing an embodiment in which the present invention is applied to two memory cell arrays having different numbers of different parallel input/output bits;

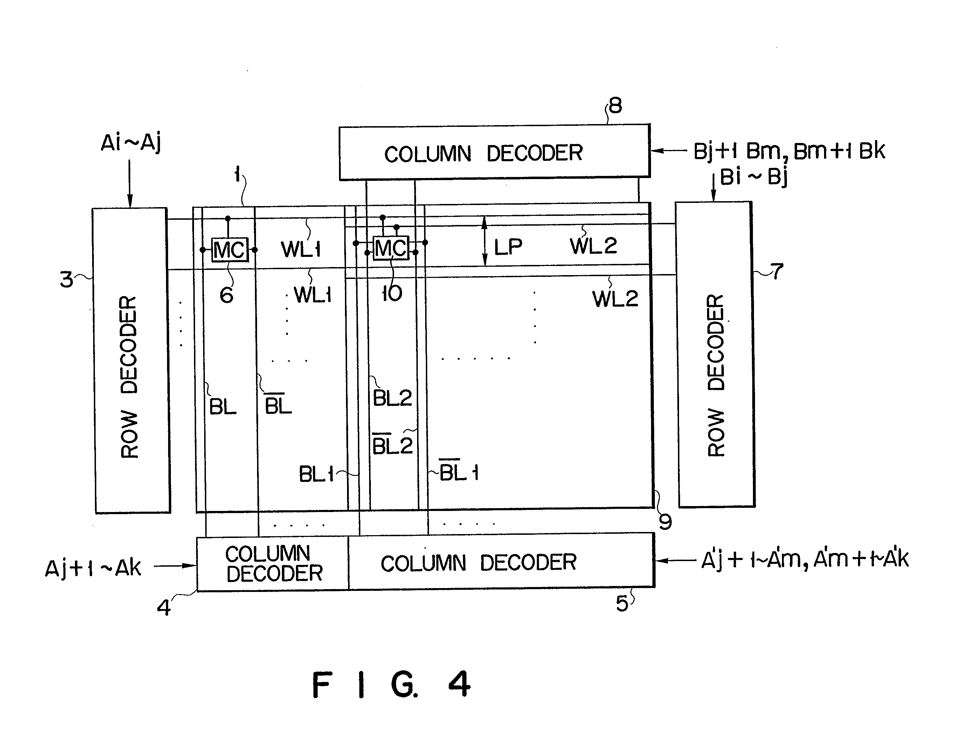

Fig. 4 is a block diagram showing an embodiment in which the invention is applied to two memory cell arrays constituted by memory cells of different structures;

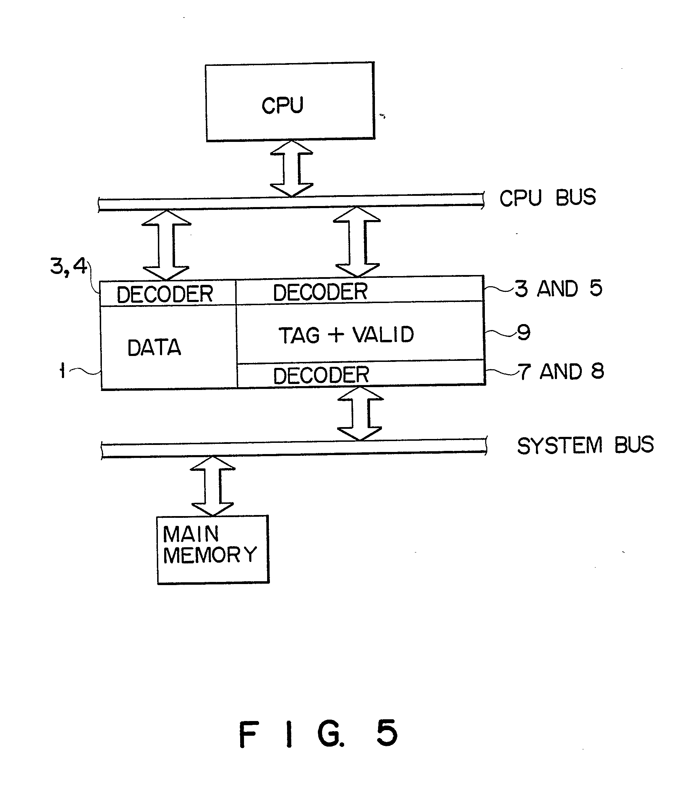

Fig. 5 is a block diagram showing an example of a system using a memory device according to the embodiment of Fig. 4;

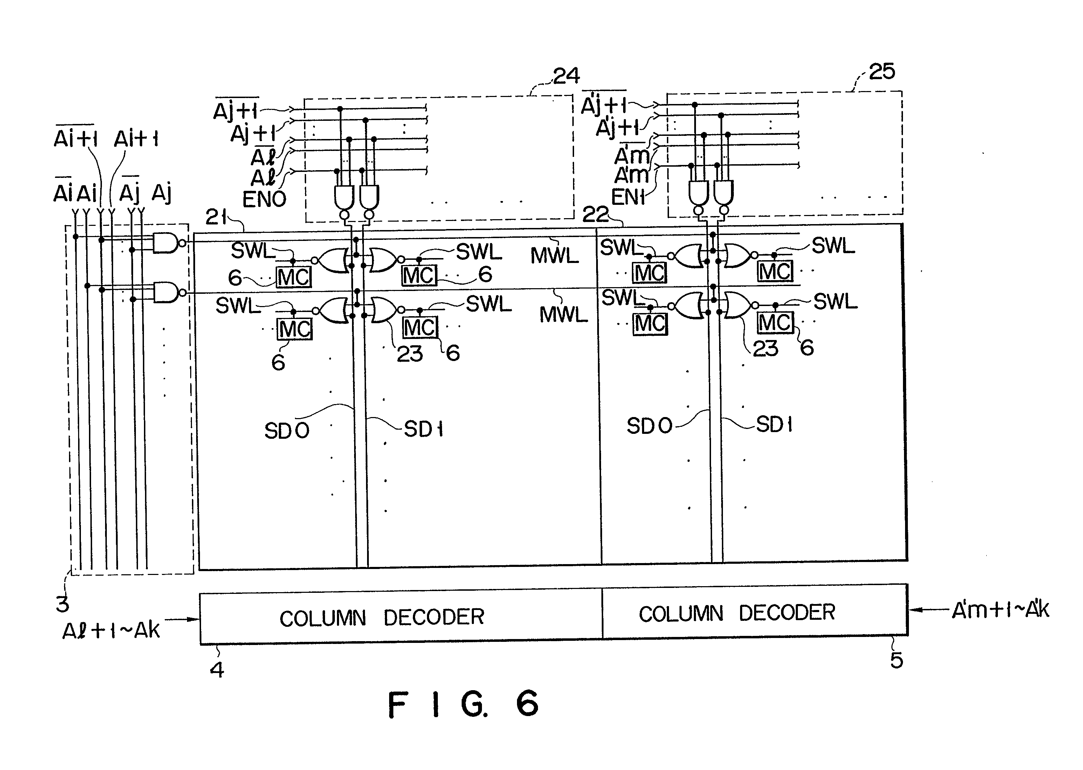

Fig. 6 is a block diagram showing an embodiment in which the invention is applied to two memory cell arrays having divided bit-line structure;

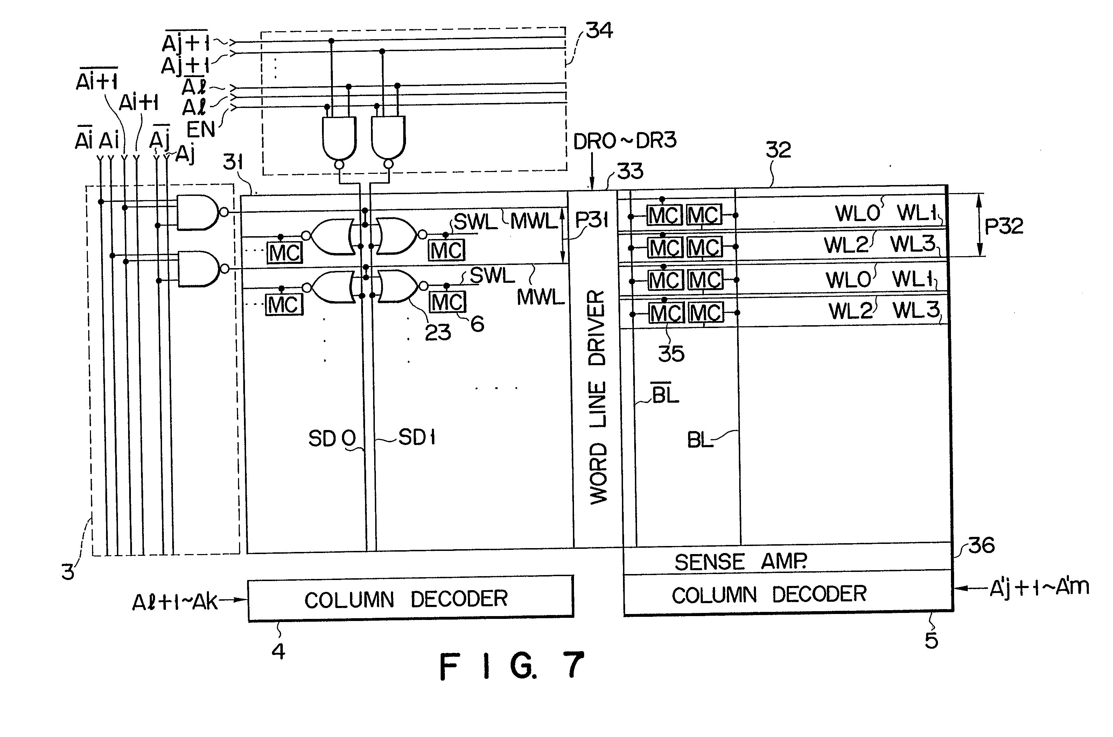

Fig. 7 is a block diagram showing an embodiment in which the invention is applied to two memory cell arrays having different numbers of rows;

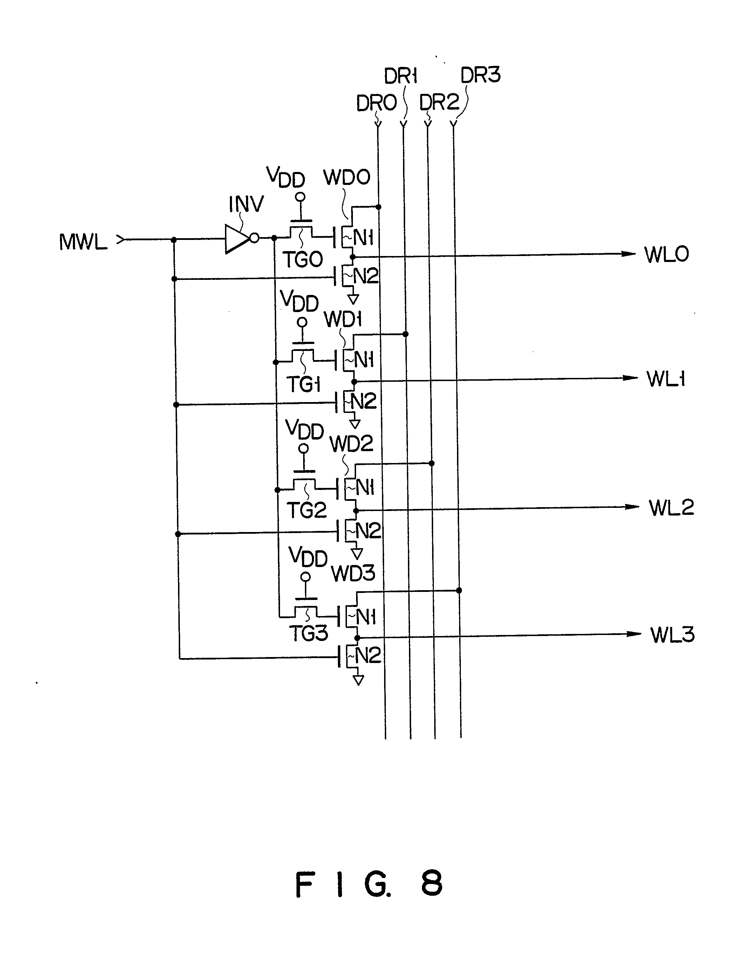

Fig. 8 is a circuit diagram showing a typical unit of a word line driver shown in Fig 7; and

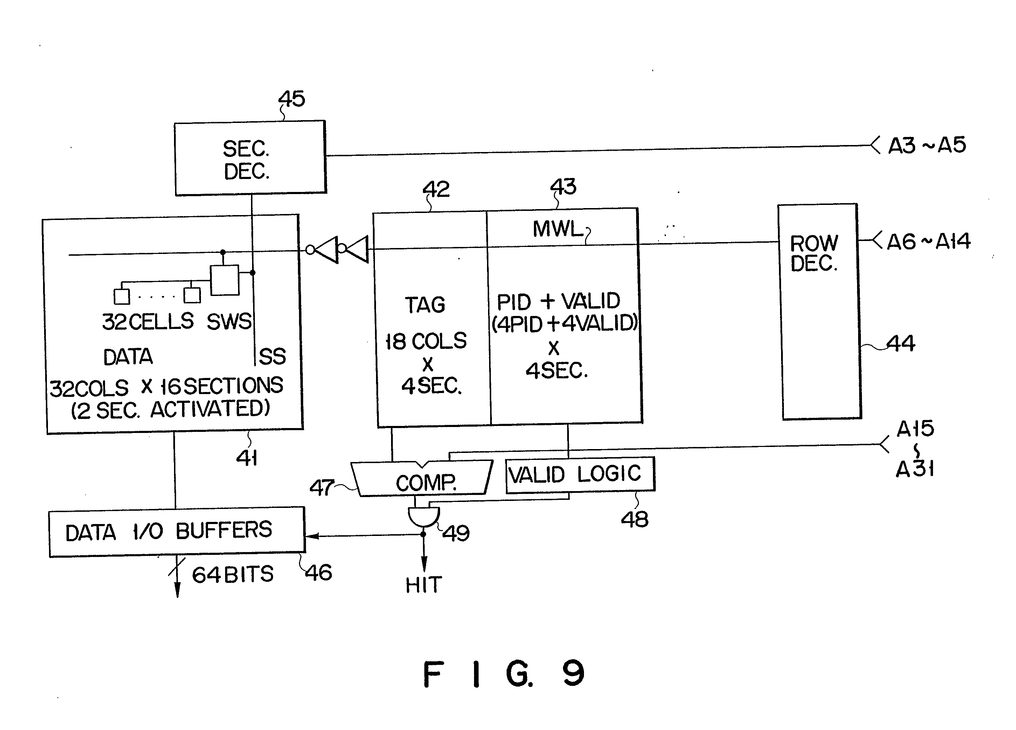

Fig. 9 is a block diagram showing an embodiment in which the invention is applied to a cache memory having three memory cell arrays.

An embodiment of the present invention will now be described in detail, with reference to Fig. 3.

Fig. 3 shows a memory section of a memory-containing logic LSI. The LSI of Fig. 3 having memory cell arrays 1 and 2 of different structures; row decoder 3 for selecting rows, which are provided commonly for memory cell arrays 1 and 2; column decoder for selecting columns of memory cell array 1; and column decoder 5 for selecting columns of memory cell array 2. Each of memory cell arrays 1 and 2 is constituted by, for example, two-dimensionally arranged static-type memory cells 6. The storage capacity (number of cells) of memory cell array 1 differs from that of memory cell array 2. Also, the number of bits of data, which can be accessed by a single access operation, differs between memory cell arrays 1 and 2. The number of rows and row pitch LR of memory cell array 1 are identical to those of memory cell array 2. A plurality of word lines WL are connected to row decoder 3, and each word line WL is commonly connected to mutually corresponding memory cells 6 of memory cell arrays 1 and 2. Address signals Ai to Aj which are common to memory cell arrays 1 and 2 are supplied to row decoder 3. Pairs of bit lines BL and $\overline{BL}$ are connected to column decoders 4 and 5, and each pair of bit lines BL and $\overline{BL}$ are connected to memory cell 6 of the corresponding column. Column decoders 4 and 5 receive non-common address signals Aj+1 to Ak and A'j+1 to A'k.

Since row decoder 3 is commonly used for memory cell arrays 1 and 2, it is therefore sufficient to provide a single row decoder, with the result that the capacity of a gate input section can be made smaller, and the signal lines for common address signals Ai to Aj made shorter, in comparison to the prior art. Thus, the floating capacity of the common address signal lines can be decreased, and as a result, common address signals Ai to Aj can be transmitted at high speed, and memory cell arrays 1 and 2 quickly accessed.

With the structure of Fig. 3, memory cell arrays 1 and 2 can be arranged in series in the columns direction, and a rectangular pattern can be employed for the memory cell arrays, resulting in a decrease in the area occupied by memory cell arrays 1 and 2. In addition, since only one row decoder is needed (two row decoders are needed in the prior art), the area of the chip can be reduced in size by the equivalent of the space required by a second decoder. Thus, the chip size can be decreased, and the chip cost reduced.

Fig. 4 shows a part of a cache memory according to a second embodiment of the present invention. This cache memory comprises first memory cell array 1 having one port, including two-dimensionally arranged memory cells 6; second memory cell array 9 having two ports, including two-dimensionally arranged memory cells 10; row decoder 3 commonly used for the first ports of memory cell arrays 1 and 9; column decoder 4 exclusively used for memory cell array 1; column decoder 5 exclusively used for the first port of memory cell array 9; row decoder 7 exclusively used for the second port of memory cell array 9; and column decoder 8 exclusively used for the second port of memory cell array 9. Row decoder 7 is located opposite to row decoder 3, with memory cell arrays 1 and 9 interposed therebetween, while column decoder 8 is located opposite to column decoder 5, with memory cell array 9 interposed therebetween. Memory cell arrays 1 and 9 have the same number of rows and row pitch LP.

Row decoder 3 receives address signals Ai to Aj which are common for the first and second memory cell arrays 1 and 9. A plurality of word lines WL1 are connected to row decoder 3, each word line WL1 being also connected commonly to memory cells 6 and 10 of the corresponding row of memory cell arrays 1 and 9. Address signals Aj + 1 to Ak are supplied to column decoder 4, to which pairs of bit lines BL and $\overline{BL}$ are connected, each pair of bit lines BL and $\overline{BL}$ being also connected to a memory cell 6 of the corresponding column. Address signals $A'j + 1$ to $A'm$ and $A'm + 1$ to $A'k$ are supplied to column decoder 5, to which pairs of bit lines BL1 and $\overline{BL1}$ are connected, each pair of bit lines BL1 and $\overline{BL1}$ being also connected to the first port of memory cell 10 of the corresponding column. Address signals Bi to Bj are supplied to row decoder 7, to which a plurality of word lines WL2 are connected, each word line WL2 being also connected to the second port of memory cell 10 of the corresponding row of memory cell array 9. Address signals Bj + 1 to Bm and Bm + 1 to Bk are supplied to column decoder 8, to which pairs of bit lines BL2 and $\overline{BL2}$ are connected, each pair of bit lines BL2 and $\overline{BL2}$ being also connected to the second port of memory cell 10 of the corresponding column. The structure of each memory cell 6, 10 can be conventional.

Each memory cell 6 of first memory cell array 1 is selected by address signals Ai to Aj and Aj + 1 to Ak, the first port of each memory cell 10 of second memory cell array 9 is selected by address signals Ai to Aj and $A'j + 1$ to $A'k$, and the second port of each memory cell 10 is selected by address signals Bi to Bj and Bj + 1 to Bk.

In second memory cell array 9, the first port is accessed by a combination of row decoder 7 and column decoder 5, and the second port is accessed by a combination of row decoder 7 and column decoder 8. In first memory cell array 1, accessing is performed by row decoder 3 and column decoder 4. Two-port type memory cell array 9 can incidentally, be replaced with a three-port type memory cell array.

According to the structure shown in Fig. 4, high-speed operation and reduction in chip size and cost can be realized, for the reasons set forth above in connection with the structure shown in Fig. 3.

The cache memory having a one-port memory and a two-port memory, as shown in Fig. 4, is used, for example, in a computer system in which a CPU bus and a system bus are separated from one other. An example of this type of computer system will now be described, with reference to Fig. 5.

Referring to Fig. 5, memory cell array 1 is used to retain data, and memory cell array 9 is used to retain TAG + Valid data. Address signals on a CPU bus are supplied to decoders 3 to 5, whereas decoders 7 and 8 are supplied with address signals on a system bus. Data to be written in or read out from a memory cell selected by address signals on the CPU bus is transferred through CPU bus, and that read out from the second port of memory cell array 9 is fed to a main memory through the system bus.

In the structure of Fig. 5, first memory cell array 1 is accessed only from the CPU, whereas second memory cell array 9 is accessed both from an external device connected to the system bus and from the CPU.

Fig. 6 shows a part of a memory-containing type logic LSI according to a third embodiment of the present invention. Referring to Fig. 6, memory cell arrays 21 and 22 have different numbers of parallel input/output bits, as well as having static-type memory cells 6, and a divided word line structure (main word lines MWL and subword lines SWL).

In addition, cell arrays 21 and 22 have the same number of rows and the same main word pitch, are arranged in series in the tow direction and, have a rectangular pattern as a whole. Arrays 2l and 22 are commonly connected to row decoder 3, to which address signals Ai to Aj for selecting rows of memory cell arrays 21 and 22 are supplied (although, in the figure, address signals $\overline{Ai}$ to $\overline{Aj}$ are supplied from an external section, they can also be produced within the decoder). Also connected to row decoder 3 are main word lines MWL, each of which is additionally connected to a section select gate circuit 23 (a NOR gate in the figure) of the corresponding row of memory cell arrays 21 and 22.

Section decoder 24 is connected to memory cell array 21, and section decoder 25 is connected to memory cell array 22. Address signals Aj+1 to A$\ell$ for section select in memory cell array 21, along with activation control signal EN0, are supplied to section decoder 24 (although, in the figure, address signals Aj+1 to A2 are supplied from an external section, they can also be produced within the decoder) Address signals $\overline{Aj+1}$ to $\overline{A\ell}$ for section select in memory cell array 22, along with activation control signal EN1, are supplied to section decoder 25 (although address signals $\overline{Aj+1}$ to $\overline{A\ell}$ are supplied from an external section in the figure, these can also be produced within the decoder). Section lines SD0, SD1...are connected to each of section decoders 24 and 25, and also to gate circuits 23 of the corresponding sections of memory cell arrays 21 and 22.

Subword lines SWL are connected to gate circuits 23, each subword line SWL also being connected to a plurality of memory cells 6 (for example, four in array 21, and eight in array 22) of the corresponding row.

In the embodiment of Fig. 6, as in the embodiments of Figs. 3 and 4, memory cell arrays 21 and 22 column decoders 4 and 5. Column selection address signals $\overline{A\ell+1}$ to $\overline{Ak}$ are supplied to column decoder 4, and column selection address signals $\overline{A\ell+1}$ to $\overline{Ak}$ are supplied to column decoder 5. Each column decoder is connected to bit lines (not shown) and to memory cells of the corresponding columns.

The operation of the memory circuit of Fig. 6 will now be described. Row decoder 3 decodes address signals Ai to Aj, and sets the potential of one of main word lines MWL to an active level (a low level in the figure), thus selecting a row in memory cell arrays 21 and 22. Section decoder 24 is activated when activation control signal EN0 is in the active state ("1" level in this embodiment), to decode address signals Aj+1 to A$\ell$ and set the potential of one of section lines SD0, SD1... of memory cell array 21 to a low level, thus selecting a section line. As a result, the output level of gate circuit 23 connected to the selected section line and selected main word line MWL is set to "1", and the potential of the corresponding subword line SWL is set to the active level (high level). In this way, memory cells 6 connected to the subword line SWL are selected. Column decoder 4 decodes address signals A$\ell$+1 to Ak, selects columns of memory cell array 21, and performs data write-in/read-from the selected memory cell through bit lines (not shown).

The same operation is performed with respect to memory cell array 22. Namely, main word bit MWL is selected by row decoder 3, and a section line is selected by section decoder 25 when activation control signal EN1 is in the active level. Upon selection of the section line and the main word line, subword line SWL is selected, and column designated by the address signals are selected by column decoder 5.

With the structure of Fig. 6, high-speed operation and reduction in chip size and cost can be realized for the reasons set forth above in connection with the embodiment of Fig. 3. Even if, in the case of the structure of Fig. 6, the number of common address signals of memory cell arrays 21 and 22 is small, row decoder 3 can still be commonly used by both cell arrays. By performing section selection of the memory cell arrays, the number of activated memory cells may be made small. Since the two memory cell arrays are individually activated/inactivated by activation control signals EN0 and EN1, only one of the two memory cell arrays can be accessed if necessary, thus saving power consumption.

Fig. 7 shows a memory-containing type logic LSI according to a fourth embodiment of the present invention. Referring to Fig. 7, memory cell arrays 31 and 32 are arranged with word line driver 33 interposed therebetween. Memory cell arrays 31 and 32 have a rectangular pattern as a whole, and are connected commonly to row decoder 3.

First memory cell array 31 is a static-type memory cell array having a divided word line structure, and includes section decoder 34 and column decoder 4. Row decoder 3 receives address signals Ai to Aj which are to be commonly used in cell arrays 31 and 32, section decoder 34 receives section selection address signals Aj+1 to A$\ell$ and activation control signal EN, and column decoder 4 receives column selection address signals A$\ell$+1 to Ak.

In contrast, second memory cell array 32 comprises two-dimensionally arranged dynamic-type memory cells 35, and has four times the number of rows of first memory cell array 31. One main word line of first memory cell array 31 corresponds to four word lines WL0 to WL3 of second memory cell array 32. Each dynamic-type memory cell 35 is connected to a corresponding one of word lines WL0 to WL3. Memory cells 35 connected to word lines WL0 and WL2 are also connected to bit line BL, and those connected to word lines WL1 and WL3 are also also connected to bit line $\overline{BL}$. Bit

lines BL and $\overline{BL}$ are in turn, connected to sense amplifier 36. Column decoder 5 for memory cell array 32 is provided adjacent to sense amplifier 36, and receives address signals $A'j+1$ to $A'm$ for selecting columns in memory cell array 32. The pitch of main word lines MWL (or subword lines SWL) of first memory cell array 31 is larger than that of word lines WL0 to WL3 of second memory cell array 32 by a positive integer number of times (in this embodiment, four times).

Word line driver 33 is connected to main word lines MWL of first memory cell array 31 and word lines WL0 to WL3 of second memory cell array 32. When main word lines MWL are activated, word line driver 33 selects and activates one of the corresponding four word lines WL0 to WL3, in accordance with word line drive signals DR0 to DR3. Fig. 8 shows an example of word line driver 33 for driving a unit of word lines WL0 to WL3.

As can be seen in Fig. 8, word line drive circuits WD0 to WD3 are provided for driving corresponding word lines WL0 to WL3, the word lines being connected to series nodes of the drive circuits. Each of word line drive circuits WD0 to WD3 is constituted by series-connected N-channel MOS transistors N1 and N2. The sources of transistors N2 are grounded, and the gates thereof are commonly connected to the corresponding main word line MWL of first memory cell array 31. The drains of transistors N1 are connected to input nodes of word line drive signals DR0 to DR3, and the gates thereof are connected to first terminals of transfer gates TG0 to TG3. The gates of transfer gates TG0 to TG3 are connected to $V_{DD}$ voltage nodes, and second terminals of transfer gates TG0 to TG3 are commonly connected to an output terminal of inverter INV. An input terminal of inverter INV is connected to the corresponding main word line MWL.

The operation of the word line driver shown in Fig. 8 will now be described. When main word line MWL is in the inactive state (high level), each transistor N2 is turned on, and word lines WL0 to WL3 are set to the low level (inactive state). When main word line MWL is in the active level (low level), each transistor N2 is turned off, and the output of inverter INV is set to the high level. Thus, transfer gates TG0 to TG3 are turned on, as well as each transistor N1. In this state, one of word line drive signals DR0 to DR3 is set to the active state (high level), and the others set to the inactive state (low level). Only a word line connected to transistor N1, to which the word line drive signal of the active state is supplied, is set to the high level (active state), the other word lines being set to the low level (inactive state).

The operation of the memory device shown in Fig. 7 will now be described. When memory cells in memory cell array 31 are selected, row address signals Ai to Aj, each indicating a row of memory cells 6 (to be selected), are supplied to row decoder 3, section address signals $Ai+1$ to $A\ell$ indicating a section (to be selected) and activation control signal EN are supplied to section decoder 34, and column addresses $A\ell+1$ to Ak indicating a column (to be selected) are supplied to column decoder 4. In this way, desired memory cells in memory cell array 31 are selected. On the other hand, when memory cells 35 in memory cell array 32 are selected, row address signals Ai to Aj indicating main word line MWC corresponding to word lines WL0 to WL3 (to be selected) are supplied to row decoder 3, word line drive signals DR0 to DR3 indicating word lines WL0 to WL3 (to be selected) are supplied to word line drive circuit 33, and column address signals $A'\ell+1$ to $A'k$ indicating a column to be selected are supplied to column decoder 5. In this manner, desired memory cells 35 in memory cell array 32 are selected.

With the structure of Fig. 7, high-speed operation and reduction in chip size and cost can be realized, for the reasons set forth above in connection with the embodiment of Fig. 3. Since static-type memory cell array 31 can be activated/inactivated by activation control signal EN, and dynamic-type memory cell array 32 can be activated/inactivated by word line drive signals DR0 to DR3, the two memory cell arrays can therefore be independently activated. If only one of the memory cell arrays is to be activated, the other memory cell array can be set in the inactive state, thereby saving on power consumption.

Asynchronous accessing can be performed on static-type memory cell array 31 by activating activation control signal EN, while synchronous accessing can be performed on dynamic-type memory cell array 32 by selectively activating word line drive signals DR0 to DR3 in accordance with synchronizing signals.

The above embodiments specifically apply to the case where two memory cell arrays having different structures are combined. However, the present invention is not limited to these embodiments, and three or more memory cell arrays may be combined. In this regard, an embodiment in which three memory cell arrays having different structures are combined will now be described with reference to Fig. 9.

Fig. 9 shows a main part of a cache memory device which comprises DATA memory 41, TAG memory 42, and PID + VALID memory 43. DATA memory 41, for storing data, has a divided word line structure, and includes 16 sections each consisting of 32 columns. When two sections of DATA memory 41 are simultaneously activated, 64 bit data are output in parallel. TAG memory 42, for storing TAG data, is constituted by a single port memory, has a divided word line structure, and includes 4 sections each consisting of 18 columns. PID + VALID memory 43 stores PID (process ID) data and VALID data, and comprises an array for storing PID data and one for storing VALID data. The array for storing PID data comprises CAM (content addressable memory) cells, has a divided word line structure, and includes four sections each consisting of four columns. The array for storing VALID data is constituted by a dual port memory, and, like that for storing PID data, has a divided word line structure, and includes four sections each consisting of four columns.

All three memories have the same number of rows (29 in the figure). Row decoder 44 is commonly provided for the three memories, and main word lines MWL, connected to row decoder 44, are provided for respective rows. Section word line selectors SWS are connected to main word lines MWL, and section word line SWL is connected to selector SWS. Memory cells are connected to section word line SWL.

Section decoder 45, for selecting sections in DATA memory 41, receives address signals A3 to A5, and is line SS, in turn, is connected to corresponding section word line selector SWS. TAG memory 42 and PID + VALID memory 43 are connected to section (not shown).

Data are input to and output from DATA memory 41 through data input/output buffer 46. 16-bit output data of TAG memory 42 is supplied to one input terminal of comparator 47, the other input terminal of comparator 47 receiving TAG address signals A15 to A31. An 8-bit out-put of PID + VALID memory 43 is fed to VALID logic circuit 48. Output signals of comparator 47 and VALID logic circuit 48 are supplied to AND gate 49. An output data signal from AND gate 49 indicates a cache hit, and is fed to a control terminal of input/output buffer 46.

Data is read out from the cache memory of Fig. 9 in the following manner.

First, main word line MWL is selected by row address signals A6 to A14. A section in DATA memory 41 is selected by section address signals A3 to A5. A 64-bit readout data is fed to I/O buffer 46.

Comparator 47 outputs a high-level signal when it judges that the output data of the memory cell selected by main word line MWL and the second section address coincides with TAG address signals A15 to A31. At the same time, VALID logic circuit 48 operates of the basis of output data of PID + VALID memory 43, and outputs a high-level signal when it judges that the readout data is valid.

AND gate 49 produces a high-level signal when it judges that two input signals are at high-level, that is, when the readout TAG address and the supplied TAG address coincide with one another and the data read out from VALID logic circuit 48 is valid. This signal serves as a cache hit signal, and in response thereto, buffer circuit 46 outputs the 64-bit data read out from DATA memory 41 to outside of the cache memory device.

In the case of the above structure, the three memories commonly use a single row decoder. Common main word lines are provided for the three memories. As a result, the operation speed can be increased, and the power consumption reduced.

As is described above, according to the semiconductor integrated circuit of the present invention, the capacity of the address signal lines commonly used by two or more memory cell arrays can be reduced, and highspeed operation realized. Moreover, since the chip size can be reduced, the unit manufacturing cost can therefore be decreased, and if the memory cell arrays are controlled by activation control signals, unnecessary power consumption can be minimized. Furthermore, the operability of this invention can be enhanced if the static-type memory cell array is accessed by activation control signals in a non-synchronous manner, and the dynamic-type memory cell array by word line drive signals in a synchronous manner.

In the embodiments of Figs. 3 to 6 and 9, the pitch of word lines of each memory cell is made equal; however, this may be changed, if desired. In the embodiment of Figs. 7 and 8, it is not essential that the pitch of main word lines be four times that of word lines WL0 to WL3. However, in the case where the pitch of the main ward lines is not four times that of the ward lines, the plan view of the memory cell array is not rectangular.

Also, in all of the above embodiments, it is not essential that the word line commonly connected to a plurality of memory cell arrays be continuous. For example, as shown in Fig. 9, a drive circuit such as a buffer may be arranged midway along the word line.

## Claims

1. A single-chip integrated circuit having a memory circuit characterized by including:
a first memory cell array (1) having row and column addresses, for storing information, and constituted by a plurality of memory cells (6) arranged in a matrix of rows and columns;
a second memory cell array (2) having row and column addresses, constituted by a plurality of memory cells (6) arranged in a matrix of rows and columns, and having the same number of rows as said first memory cell array (1), having a structure different from that of said first memory cell array (1), said first and second memory cell arrays having common row addresses (Ai to Aj);

a plurality of word lines (WL) each connected to the memory cells (6) of the corresponding row of said first and second memory cell arrays (1, 2), for selecting said memory cells when the potential of the word line is set to an active level;

a decoder (3) connected to said plurality of word lines (WL), for decoding said row addresses (Ai to Aj) and setting the potential of the word line (WL) corresponding to said row addresses to the active level;

a plurality of first bit lines (BL), each connected to the memory cells (6) on a corresponding column in said first memory cell array;

a plurality of second bit lines (BL), each connected to the memory cells (6) on a corresponding column in said second memory cell array;

a first column decoder (4), connected to said first bit lines (BL) and receiving first column addresses (Aj + 1 to Ak), for writing data, via said first bit lines (BL), into the memory cells designated by said row addresses (Ai to Aj) and said first column addresses (Aj + 1 to Ak), and for reading out data, via said first bit lines (BL), from said designated memory cells; and

a second column decoder (5), connected to said second bit lines (BL) and receiving second column addresses (A'j + 1 to A'k), for writing data, via said second bit lines, into the memory cells designated by said row addresses (Ai to Aj) and said second column addresses (A'j + 1 to A'k), and for reading out data, via said second bit lines, from said designated memory cells.

2. A semiconductor device characterized by comprising:

a single-chip integrated circuit having a memory circuit including:

first memory cell array means (1), for storing information, and constituted by a plurality of memory cells (6) arranged in a matrix of rows and columns;

second memory cell array means (2), constituted by a plurality of memory cells (6, 10, 35) arranged in a matrix of rows and columns, and having the same number of rows as said first memory cell array means (1), having a structure different from that of said first memory cell array means (1), said first and second memory cell array means commonly having some (Ai to Aj) addresses;

word line means (WL; MWL, SWL, 23, 33, WL0 to WL1) connected to the memory cells of said first and second memory cell arrays means (1, 2), for selecting said memory cells;

row decoder means (3) connected to said word line means, for decoding said some (Ai to Aj) of said addresses and driving said word line means to select the memory cells designated by said some of said addresses;

first bit line means (BL), connected to the memory cells (6) of said first memory cell array means (1), for transmitting data;

second bit line means (BL), connected to the memory cells (6, 10) of said second memory cell array means (2), for transmitting data;

first column decoder means (4) connected to said first bit line means and receiving first column addresses (Aj + 1 to Ak) for writing data, via said first bit line means (BL), into the memory cells designated by said commonly used addresses (Ai to Aj) and said first column addresses (Aj + 1 to Ak), and for reading out data, via said first bit line means (BL), from said designated memory cells; and

second column decoder means (5), connected to said second bit line means and receiving second column addresses (A'j + 1 to A'k), for writing data, via said second bit line means (BL), into the memory cells designated by said commonly used addresses (Ai to Aj) and said second column addresses (A'j + 1 to A'k), and for reading out data, via said second bit line means (BL), from said designated memory cells.

3. The semiconductor device according to claim 2, characterized in that said first and second memory cell array means (1, 2) have the same number of rows.

4. The semiconductor device according to claim 2, characterized in that the number of rows of said second memory cell array means (32) is larger by a positive-integer number of times than that of said first memory cell array means (31).

5. The semiconductor device according to claim 4, characterized in that said word line means (WL) includes:

first word lines (WL), provided for respective rows of said first memory cell array means (31);

second word lines (WL0 to WL3) provided for respective rows of said second memory cell array means (32); and

word line driver means provided for each of said first word lines (WL), and connected to a plurality of corresponding ones of said second word lines (WL0 to WL3), said word line driver means receiving word line selection signals (DR0 to DR3) to drive said second word lines (WL0 to WL3) in accordance with the potential of said first word lines (WL) and said word line selection signals (DR0 to DR3).

6. The semiconductor device according to claim 2, characterized in that said first memory cell array means (1) and said second memory cell array means (2) are different from each other, at least with respect to one of the structure of the memory cells constituting the memory cell arrays, the storage capacity, and the number of parallel input/output bits.

7. The semiconductor device according to claim 6, characterized in that said first memory cell array means (1) comprises static-type memory cells, and said second memory cell array means (2) comprises dynamic-type memory cells.

8. The semiconductor device according to claim 6, characterized in that said first memory cell array means (1) comprises single-port memory cells (6),

said second memory cell array means (2) comprises dual-port memory cells (10),

said word line means (WL1) and said second bit line means (BL1) are connected to first ports of said dual-port memory cells (10), and

said second memory cell array means (2) includes a second port row decoder (7) and a second port column decoder (8), both connected to second ports of said dual-port memory cells.

9. The semiconductor device according to claim 8, characterized in that said memory circuit constitutes a cache memory contained in a data processing system, said row decoder means (3) and said first and second column decoder means (4, 5) are connected to a CPU bus connected to a CPU (central processing unit), and

said second port row decoder (7) and said second port column decoder (8) are connected to a system bus provided separately from said CPU bus.

10. The semiconductor device according to claim 2, characterized in that said first memory cell array means (1), said second memory cell array means (2), and said row decoder means (3) are arranged in a direction of rows, in a substantially rectangular pattern.

11. A memory device comprising first memory cell array means (1) for storing information, and second memory cell array means (2) having a structure different from the structure of said first memory cell array means and using part (Ai to Aj) of addresses commonly with said first memory cell array,

characterized in that said device further comprises a decoding means (3) provided commonly for and commonly connected to said first and second memory cell array means, for decoding said commonly used addresses (Ai to Aj).

EP 0 337 457 A2

**F I G. 1**

F I G. 2

F I G. 3

FIG. 4

F I G. 5

F I G. 6

EP 0 337 457 A2

F I G. 7

EP 0 337 457 A2

F I G. 8

SEC. DEC. — 45

A3 ~ A5

42    43

MWL

TAG
18 COLS
X
4 SEC.

PID + VALID
(4PID + 4VALID)
X
4SEC.

ROW
DEC.

A6 ~ A14

44

32 CELLS SWS

DATA          SS

32 COLS X 16 SECTIONS
(2 SEC. ACTIVATED)

41

A15
A31

COMP.    VALID LOGIC

47    49    48

DATA I/O BUFFERS

64 BITS    46

HIT

F I G. 9

EP 0 337 457 A2